# FASCICULE DE BREVET EUROPEEN

(11) **EP 1 433 368 B1**
(45) Date de publication et mention de la délivrance du brevet: **22.12.2004**
(21) Numéro de dépôt: 02800216.0
(22) Date de dépôt: 01.10.2002
(51) Int. Cl.: H05K 3/40, G06K 19/077, H01L 23/498

(54) **CIRCUIT ELECTRONIQUE COMPORTANT DES PONTS CONDUCTEURS ET METHODE DE REALISATION DE TELS PONTS**
ELEKTRONISCHE SCHALTUNG MIT LEITFÄHIGEN BRÜCKEN UND VERFAHREN ZUR HERSTELLUNG SOLCHER BRÜCKEN
ELECTRONIC CIRCUIT COMPRISING CONDUCTIVE BRIDGES AND METHOD FOR MAKING SUCH BRIDGES

(30) Priorité: 01.10.2001 CH 179801
(43) Date de publication de la demande: 30.06.2004
(73) Titulaire: NagraID S.A., 2301 La Chaux-de-Fonds (CH)
(72) Inventeur: DROZ, François, CH-2300 La Chaux-de-Fonds (CH)
(74) Mandataire: Wenger, Joel-Théophile
(86) Numéro de dépôt international: PCT/IB2002/004039
(87) Numéro de publication internationale: WO 2003/030601

(56) Documents cités:
- DE-A- 19 916 180
- US-A- 2 900 580
- US-A- 3 977 074
- PATENT ABSTRACTS OF JAPAN vol. 1998, no. 09, 31 juillet 1998 (1998-07-31) -& JP 10 092870 A (ROHM CO LTD), 10 avril 1998 (1998-04-10)
- PATENT ABSTRACTS OF JAPAN vol. 2000, no. 05, 14 septembre 2000 (2000-09-14) -& JP 2000 057289 A (SONY CORP), 25 février 2000 (2000-02-25) cité dans la demande
- "FABRICATION OF MULTI-CHANNEL THROUGH HOLES WITHOUT COPPER PLATING" IBM TECHNICAL DISCLOSURE BULLETIN, IBM CORP. NEW YORK, US, vol. 37, no. 2B, 1 février 1994 (1994-02-01), pages 251-252, XP000433832 ISSN: 0018-8689

## Description

La présente invention concerne un circuit électronique comportant des ponts conducteurs et une méthode de réalisation de tels ponts. Le circuit électronique comprend des pistes conductrices connectées à au moins un composant électronique. La liaison sur l'une des plages de connexion du composant nécessite la formation d'un pont électrique.

L'invention concerne des circuits fabriqués par application de plusieurs couches, notamment un substrat, une couche adhésive et une couche conductrice. On utilise ce type de circuit en particulier pour des cartes avec ou sans contact extérieur ou des étiquettes électroniques. On entend par étiquette électronique, un ensemble comprenant au moins un support souple, une antenne et un composant électronique, en général une puce. La carte ou l'étiquette électronique selon l'invention se trouve dans de nombreuses applications comme moyen d'identification, de contrôle ou de paiement.

Le sujet de la présente invention se concentre particulièrement sur des circuits électroniques comprenant un support isolant appelé substrat sur lequel est gravée une pluralité de pistes conductrices ou une bobine. Ces dernières sont reliées à au moins un composant électronique tel qu'une puce.

Il est connu de l'homme du métier des circuits électroniques où les contacts d'un composant électronique sont connectés directement par soudage ou collage conducteur sur des plages de connexion situées sous le composant. Suivant la configuration du circuit constitué par des pistes conductrices ou d'une bobine, la connexion d'un contact du composant à l'une de ces pistes nécessite un pont électrique conducteur. Ce cas se présente notamment lors de la connexion d'une bobine à une puce. En effet, les deux terminaisons de la bobine sont disposées, de part et d'autre, à l'intérieur et à l'extérieur des spires. Un des contacts de la puce est connecté directement sur une des terminaisons de la bobine et l'autre contact doit être connecté au moyen d'un pont conducteur vers la seconde terminaison de la bobine. Ce pont est généralement réalisé avec une piste conductrice passant par-dessus d'autres pistes. Afin d'éviter les courts-circuits, le pont est séparé par une portion de film isolant collée sur les pistes qu'il croise. Une autre solution consiste à traverser le substrat pour faire passer le pont par l'autre face du substrat sous les pistes conductrices pour ensuite traverser à nouveau le substrat afin d'atteindre une plage de connexion plus éloignée. Cette traversée est constituée en général par un trou percé dans une piste qui est obturé par un matériau conducteur assurant la connexion avec la piste. Le pont est soudé sur cette traversée du côté de la face opposée à celle des pistes conductrices à croiser.

Le document JP2000057289 décrit une carte sans contact comportant un circuit constitué d'une bobine reliée à une puce qui se trouve dans la zone interne des spires de la bobine. L'ensemble du circuit est collé sur un substrat souple. La terminaison interne de la bobine est connectée directement à la puce tandis que la terminaison externe traverse le substrat pour passer sous les spires de la bobine. Dans ce cas particulier d'un substrat souple et de faible épaisseur, une portion du substrat où est collée l'extrémité externe de la bobine est découpée. Elle est ensuite pliée pour passer par-dessus les spires de la bobine avant de traverser le substrat par un orifice afin de se trouver au niveau de la terminaison interne. La puce peut ainsi être connectée sur les deux terminaisons proches l'une de l'autre sur la même face du circuit.

Le document US2900580 décrit un passage formé par une fenêtre dans un substrat recouvert par une couche conductrice. La découpe de la fenêtre est effectuée dans le substrat seul pour ne conserver que la couche conductrice. Cette dernière est coupée sur trois côtés, le dernier côté étant replié sur le bord de la fenêtre pour passer sur la face opposée. Une couche isolante supplémentaire est collée sur cette face puis la fenêtre est obstruée avec de la résine.

Le document JP10092870 décrit le passage d'une piste à travers une ouverture rectangulaire formée dans le substrat en laissant apparaître la couche conductrice de la face opposée. Cette dernière est coupée sur trois côtés le long des bords de l'ouverture puis repliée sur le quatrième côté pour passer sur la face supérieure.

Les ponts électriques connus décrit ci-dessus présentent l'inconvénient principal de nécessiter des opérations délicates et onéreuses. La fabrication de très grandes quantités de circuits, cartes ou étiquettes impose des coûts minimaux et une rapidité d'exécution élevée.

Le but de la présente invention est de pallier les inconvénients décrits ci-dessus à savoir obtenir un circuit électronique utilisé par exemple dans une carte ou une étiquette très bon marché tout en conservant une fiabilité élevée. Ceci concerne en particulier la connexion d'un ou des composants électroniques sur les pistes conductrices au moyen de ponts conducteurs qui traversent le substrat.

La présente invention a également pour but de proposer une méthode de réalisation d'un tel pont conducteur.

Ce but est atteint par un circuit électronique comprenant au moins un composant électronique, un substrat, sur une première face de ce substrat est appliqué une couche adhésive et une couche conductrice constituée par une pluralité de pistes, ledit composant comportant au moins deux plages de connexion, au moins l'une de ces plages est reliée électriquement à la couche conductrice par un pont conducteur, caractérisé en ce que ce pont est formé par un segment conducteur délimité dans la couche conductrice seule, ledit segment, dépourvu de substance adhésive, traverse le substrat au moyen d'un passage et relie la plage de connexion.

Le circuit électronique selon l'invention est constitué d'une couche isolante appelée substrat, d'une couche adhésive et d'une couche conductrice collée sur le substrat. La couche conductrice comporte des pistes et/ou une bobine auxquelles est connecté un composant électronique. Les contacts du composant sont en général proches les uns des autres et disposés de façon à être soudés sur des plages de connexion situées sous le composant en face des contacts de celui-ci. Afin de connecter une piste venant d'une zone située au-delà d'autres pistes qui constituent par exemple les spires d'une bobine, il est nécessaire de croiser ces pistes. Ce croisement s'effectue par un pont qui traverse le substrat une première fois pour passer sur la face opposée sous les pistes à croiser. Un second passage à travers le substrat ramène le pont au niveau de la plage de connexion située sous le composant électronique.

Ce pont est constitué par la prolongation d'une piste provenant de la couche conductrice. Cette prolongation qui forme un segment de piste n'est pas collée au substrat. L'extrémité de ce pont est ensuite soudée sur la plage de connexion après avoir traversé deux fois le substrat.

Selon une variante préférée de l'invention, les traversées du substrat sont constituées par des incisions pratiquées dans celui-ci sans qu'il ne soit nécessaire d'enlever de la matière comme lors d'un perçage par exemple. Dans cette variante, le substrat est constitué d'une matière souple et de faible épaisseur. Ce substrat est utilisé en général pour la fabrication de cartes ou d'étiquettes électroniques.

Dans le cas des circuits où les traversées du substrat sont réalisées par perçage ou par étampage (enlèvement de matière au substrat), les ouvertures sont refermées par remplissage au moyen d'un liant après le passage du pont. Lors de l'opération de finition, par exemple laminage de couches décoratives, il reste des dépressions au niveau des passages. Pour éliminer cet inconvénient, il est nécessaire d'utiliser une plus grande quantité de liant et un laminage à haute pression, voire et à température élevée.

Les passages réalisés par des incisions dans le substrat ont l'avantage de pouvoir être refermés aisément après la traversée du pont. En effet, le laminage final du circuit électronique peut s'effectuer à une pression et une température réduite. Le procédé de fabrication est en outre simplifié car un remplissage des passages des ponts n'est plus nécessaire. Il en résulte alors un circuit comportant des faces planes sans déformations dues aux traversées du substrat. Cette planéité est de plus en plus exigée par des circuits de faible épaisseur où les composants sont noyés dans le substrat.

Ce type de circuit est utilisé fréquemment dans des étiquettes électroniques qui doivent être souple, fiable tout en ayant un coût de production très bas.

Le passage dans l'ouverture d'un segment de piste est possible grâce à la faible épaisseur des pistes issues de la couche conductrice, d'une part et à la forme arrondie du bord de l'ouverture d'autre part. Ce bord arrondi est obtenu par la pression de l'outil d'incision (lame, étampe) utilisé pour la réalisation de l'ouverture. On exploite également la souplesse du substrat pour temporairement créer un passage suffisant pour laisser passer le segment conducteur.

Ce type de traversée s'effectue autant de fois qu'il est nécessaire de croiser des pistes. La longueur du pont dépend ainsi du nombre de traversées et de l'éloignement de la plage de connexion du composant électronique. Plusieurs pistes peuvent traverser côte à côte une même incision dont la longueur dépend de la largeur et du nombre de pistes passant d'une face à l'autre du substrat.

Une variante du circuit électronique, selon l'invention, comprend une couche conductrice sur chaque face du substrat. Le passage conducteur d'une face à l'autre et/ou un pont de croisement de pistes s'effectue par une traversée réalisée par incision du substrat comme décrit plus haut.

La présente invention a aussi comme objet une méthode de fabrication d'un circuit électronique comprenant un substrat, au moins une couche adhésive et une couche conductrice constituée par une pluralité de pistes et un composant électronique, caractérisée en ce que la réalisation d'un pont entre une zone de la couche conductrice et une plage de connexion cible, comporte les étapes suivantes:
- prolonger une piste dans la couche conductrice pour constituer un segment conducteur,
- former une ouverture dans le substrat,
- dégager temporairement ladite ouverture,
- passer le segment conducteur à travers ladite ouverture,
- rabattre le segment contre la face opposée du substrat,
- refermer l'ouverture après le passage du segment conducteur,
- connecter le segment avec la plage de connexion cible.

La piste venant de la couche conductrice qui forme le segment conducteur est en général une prolongation d'une piste du circuit formé dans la couche conductrice.

L'ouverture dans le substrat est réalisée par des incisions effectuées avec une lame ou par étampage, de façon à former une languette sensiblement rectangulaire dont un petit côté est rattaché au substrat. La longueur de la languette est déterminée par l'épaisseur et l'élasticité du substrat et la largeur par celle de la ou des segments conducteurs constituant le ou les ponts qui doivent traverser le substrat. Cette languette est poussée vers le haut, pour dégager une ouverture suffisante afin de laisser passer le ou les segments. La languette est ensuite relâchée après le passage des segments de manière à fermer l'ouverture et à conserver la planéité d'origine du circuit ou de la carte. Les segments sont ensuite rabattus contre la face opposée du substrat et dirigés vers une zone prévue pour une seconde traversée du substrat si nécessaire. Une seconde languette doit être incisée pour faire revenir, cette fois dans le sens inverse, le ou les segments sur la face conductrice. Ces segments seront ensuite connectés aux plages de connexion cible du ou des composants électroniques. Dans une phase finale du procédé, la colle de la couche adhésive est activée à chaud pour fixer le pont sur le substrat.

Dans le cas de la variante double face (couche conductrice sur les deux faces du substrat), une seule languette est nécessaire pour réaliser une connexion avec l'autre face au moyen d'un segment de piste provenant de la première face.

Il résulte des caractéristiques décrites ci-dessus une méthode de réalisation d'une traversée d'un substrat d'un circuit électronique par un pont conducteur qui nécessite un nombre réduit d'opérations et qui, de plus, sont peu coûteuses. Toutes les languettes nécessaires peuvent être incisées dans le substrat lors d'une même étape et un outillage adéquat les maintient incurvées (ouvertes) pour le passage des segments. Le redressement des languettes en position plane et le rabattement des segments contre les faces peut s'effectuer lors de l'opération de laminage.

L'invention sera mieux comprise grâce à la description détaillée qui va suivre et qui se réfère aux dessins annexés qui sont donnés à titre d'exemple nullement limitatif, dans lesquels:
- la figure 1 représente une vue en perspective d'une portion de circuit avec un pont passant sous des pistes.
- la figure 2 représente une vue de dessus d'une portion de circuit avec deux languettes prédécoupées et un segment de piste avant la traversée du substrat.
- la figure 3 représente une coupe de la portion de circuit illustrée par la figure 2
- La figure 4 représente la première languette incurvée et le segment de piste passant par l'ouverture.
- La figure 5 représente le segment de piste rabattu contre le substrat et la première languette redressée dans sa position initiale.
- La figure 6 représente la seconde languette incurvée et le segment de piste passant par l'ouverture.
- La figure 7 représente la seconde languette redressée.
- La figure 8 représente le segment de piste rabattu contre le substrat et la seconde languette redressée.
- La figure 9 représente une vue de dessus du résultat final avec le pont et les deux traversées du substrat
- La figure 10 représente une vue de dessus d'une portion de circuit avec un composant placé et soudé sur les pistes
- la figure 11 représente une coupe de la portion de circuit illustrée par la figure 10
- La figure 12 représente une coupe comme la figure 11 mais avec un composant logé dans le substrat et soudé sous les pistes.

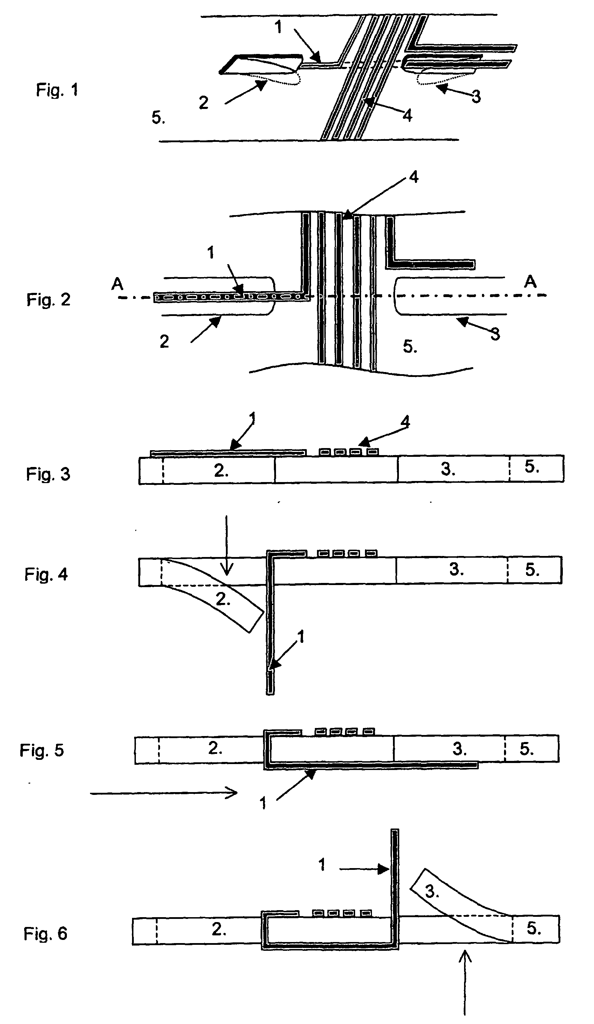

La figure 1 illustre en perspective un pont conducteur (1) qui traverse un substrat (5) par une première fente pour passer sous les pistes (4) et retraverser le substrat (5) par une seconde fente. Les fentes sont constituées par une incision qui est formée lors de la découpe des languettes (2) et (3). Ces dernières sont montrées levées afin de mieux distinguer le passage de la piste à travers le substrat (5). Le pont est réalisée par une prolongation d'une piste ou segment de piste (1) qui n'est pas collé au substrat (5). Selon une étape non illustrée, la couche adhésive est déposée sélectivement sur le substrat de sorte que la région ou la piste conductrice formera le segment conducteur soit libre de colle.

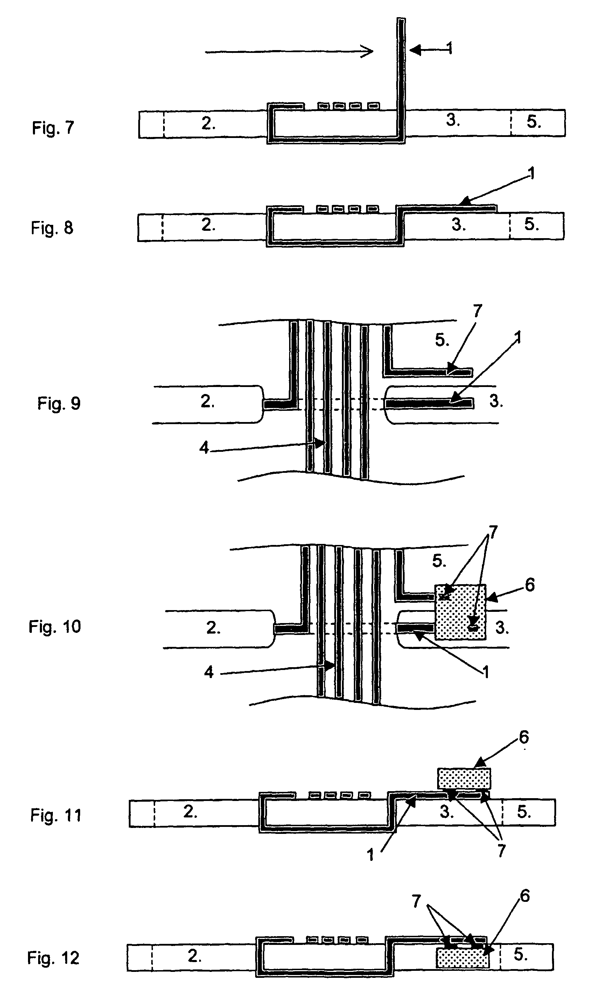

Les figures 2 à 9 illustrent les différentes étapes de la réalisation du pont représenté par la figure 1. Les figures 10 à 13 montrent la connexion d'un composant électronique après la réalisation du pont.

La figure 2 illustre les deux languettes (2) et (3) prédécoupées de forme rectangulaire, un des petits côtés des languettes reste rattaché au substrat. Ces découpes sont effectuées de part et d'autre des pistes (4) que le segment de piste (1) doit croiser.

La figure 3 est une vue en coupe selon l'axe A-A de la figure 2 qui illustre la première étape de la réalisation du pont constitué par le segment de piste (1). Le segment (1) recouvre la première languette (2) sans adhérer.

La figure 4 montre la première languette (2) prédécoupée auparavant, incurvée vers le bas de façon à dégager une ouverture suffisante pour permettre le passage du segment de piste (1). Ce dernier est plié une première fois sur le bord de l'ouverture dégagée par la languette, le segment (1) est dirigé vers le bas à travers l'ouverture.

La figure 5 montre la première languette (2) redressée dans le même plan que le substrat (5) c'est-à-dire dans la même position qu'avant le passage du segment de piste (1 ). Ce dernier est rabattu contre la face opposée du substrat (5) et dirigé vers la seconde languette (3) prédécoupée en passant sous les pistes (4).

La figure 6 montre le second passage du segment de piste (1) à travers l'ouverture dégagée par la seconde languette (3). Cette fois cette languette (3) est incurvée vers le haut pour laisser passer le segment (1) à travers le substrat (5). Le segment de piste (1) est ensuite plié sur le bord de l'ouverture comme lors de son premier passage à travers le substrat (5).

La figure 7 montre la seconde languette de retour dans sa position initiale avec le segment de piste (1) traversant le substrat (5).

Les figures 8 et 9 illustrent la position finale du segment de piste (1) qui est rabattu contre la face du substrat (5) à côté des autres pistes. Une partie du segment de piste (1) devient une plage de connexion (7) pour le composant électronique (6). Le premier contact est soudé sur le segment de piste (1) et l'autre sur la piste préexistante voisine comme illustré par les figures 10 et 11.

La figure 12 montre une autre manière de connecter le composant (6) sur les pistes conductrices. Le composant est logé dans une fenêtre découpée dans le substrat de façon à présenter ses contacts en face des pistes qui passent dans la fenêtre. Cet assemblage particulier permet de noyer le composant dans le substrat afin d'obtenir une étiquette d'épaisseur minimale.

Selon une autre variante de l'invention, au lieu d'utiliser des languettes étampées dans le substrat, le passage d'un pont d'une face à l'autre du substrat est réalisé par un orifice formé par enlèvement de matière c'est-à-dire par perçage ou étampage. De même que pour la version à languette, le pont est formé par un segment conducteur prolongeant une piste issue de la couche conductrice. Ce segment dépourvu de substance adhésive traverse ledit substrat par l'orifice pour effectuer une connexion sur l'autre face.

Cette méthode permet de réaliser des circuits simple face très bon marché tout en conservant la possibilité de disposer d'une ou plusieurs pistes qui enjambent d'autres pistes.

Si l'on souhaite réaliser une carte à puce par exemple, les orifices seront refermés par apport d'une substance de remplissage comme de la résine époxy par exemple. Un laminage final assure la planéité du circuit.

## Revendications

1. Circuit électronique comprenant au moins un composant électronique (6), un substrat (5), constitué d'une matière isolante souple, sur une première face de ce substrat (5) est appliqué une couche adhésive et une couche conductrice constituée par une pluralité de pistes (4), ledit composant (6) comportant au moins deux plages de connexion (7), au moins l'une de ces plages (7) est reliée électriquement à la couche conductrice par un pont conducteur, **caractérisé en ce que** le substrat comporte au moins une languette (2, 3) sensiblement rectangulaire réalisée par des incisions dans le substrat (5) sur trois côtés, le dernier côté étant attaché audit substrat (5) et **en ce que** le pont est formé par un segment (1) conducteur délimité dans la couche conductrice seule, ledit segment (1), dépourvu de substance adhésive, traverse la substrat (5) par l'une des incisions de ladite languette (2, 3) et relie la plage de connexion (7).

2. Circuit électronique selon la revendication 1, **caractérisé en ce que** le substrat (5) comprend une seconde face avec une seconde couche adhésive et une seconde couche conductrice, et **en ce que** ce pont est formé par un segment (1) conducteur délimité dans la seconde couche conductrice seule, ledit segment (1), dépourvu de substance adhésive, traverse le substrat (5) par l'une des incisions de ladite languette (2, 3) et relie la plage de connexion (7) et/ou la première couche conductrice.

3. Circuit électronique selon les revendications 1 et 2, **caractérisé en ce qu'**une pluralité de ponts formés par des segments (1) de pistes traversent le substrat (5) par une même incision.

4. Circuit électronique selon les revendications 1 à 3, **caractérisé en ce qu'**au moins un pont formé par un segment (1) de piste traverse le substrat (5) autant de fois qu'il est nécessaire de croiser des pistes (4) appartenant à la couche conductrice pour atteindre la plage de connexion (7).

5. Carte à puce ou étiquette électronique **caractérisée en ce qu'**elle comprend un circuit électronique selon l'une des revendications 1 à 4.

6. Méthode de fabrication d'un circuit électronique comprenant un substrat (5), constitué d'une matière isolante souple, au moins une couche adhésive et une couche conductrice constituée par une pluralité de pistes (4) et un composant électronique (6), **caractérisée en ce que** la réalisation d'un pont entre une zone de la couche conductrice et une plage de connexion (7) cible, comporte les étapes suivantes:
- prolonger une piste dans la couche conductrice pour constituer un segment (1) conducteur,
- inciser dans le substrat (5), une languette (2, 3) sensiblement rectangulaire dont l'un des côtés est attaché au substrat (5).
- dégager temporairement une ouverture au moyen d'une pression sur la languette (2, 3), ladite languette (2, 3) s'incurvant le long du côté attaché au substrat (5).
- passer le segment (1) conducteur à travers ladite ouverture,
- rabattre le segment (1) conducteur contre la face opposée du substrat (5),
- refermer l'ouverture après le passage du segment (1) conducteur par redressement de la languette (2, 3) vers sa position initiale dans le plan du substrat (5).
- connecter le segment (1) conducteur avec la plage de connexion (7) cible.

7. Méthode selon la revendication 6, **caractérisée en ce que** la plage de connexion cible est placée sur la couche conductrice et **en ce que** le segment (1) conducteur retourne à ladite couche conductrice par une seconde traversée du substrat au moyen d'une languette (2, 3) supplémentaire, ledit segment (1) conducteur étant alors fixé sur le substrat (5) par l'activation de la colle provenant de la couche adhésive.

## Patentansprüche

1. Elektronische Schaltung mit zumindest einem elektronisches Bauteil (6) und einem Substrat (5), das aus einem weichen, isolierenden Material besteht, auf eine erste Seite dieses Substrats (5) wird eine Kleberschicht sowie eine aus einer Mehrzahl von Leiterbahnen (4) bestehende Leiterschicht aufgebracht, wobei das genannte Bauteil (6) zumindest zwei Kontaktierstreifen (7) umfasst, und zumindest einer dieser Streifen (7) wird über eine Leiterbrücke elektrisch an die Leiterschicht angeschlossen, **dadurch gekennzeichnet, dass** das Substrat zumindest eine im Wesentlichen rechteckige Zunge (2, 3) umfasst, die durch Einschnitte auf drei Seiten im Substrat (5) realisiert wird, während die vierte Seite am Substrat (5) verbleibt, und dadurch, dass die Brücke aus einem Leitersegment (1) gebildet wird, das in der Leiterschicht allein ausgegrenzt ist, wobei dieses Segment (1), das frei von Kleber ist, das Substrat (5) über einen der Einschnitte der Zunge (2, 3) durchquert und den Kontaktierstreifen (7) verbindet.

2. Elektronische Schaltung nach Anspruch 1, **dadurch gekennzeichnet, dass** das Substrat (5) eine zweite Seite mit einer zweiten Kleberschicht und einer zweiten Leiterschicht umfasst, und dadurch, dass diese Brücke durch ein Leitersegment (1) gebildet wird, das in der zweiten Leiterschicht allein ausgegrenzt ist, wobei dieses Segment (1), das frei von Kleber ist, das Substrat (5) über einen der Einschnitte der Zunge (2, 3) durchquert und den Kontaktierstreifen (7) und/oder die erste Leiterschicht verbindet.

3. Elektronische Schaltung nach Ansprüchen 1 und 2, **dadurch gekennzeichnet, dass** eine Mehrzahl von durch Leiterbahnsegmente (1) gebildete Brücken das Substrat (5) durch ein und denselben Einschnitt durchqueren.

4. Elektronische Schaltung nach Ansprüchen 1 bis 3, **dadurch gekennzeichnet, dass** zumindest eine durch ein Leiterbahnsegment (1) gebildete Brücke das Substrat (5) so viele Male durchquert, wie erforderlich ist, um die zur Leiterschicht gehörenden Leiterbahnen (4) zu kreuzen und den Kontaktierstreifen (7) zu erreichen.

5. Chipkarte oder elektronisches Etikett, **dadurch gekennzeichnet, dass** sie eine elektronische Schattung nach einem der Ansprüche 1 bis 4 umfassen.

6. Verfahren zur Fertigung einer elektronischen Schaltung mit einem Substrat, das aus einem weichen, isolierenden Material besteht, mit zumindest einer Kleberschicht und mit einer aus einer Mehrzahl von Leiterbahnen (4) bestehenden Leiterschicht sowie mit einem elektronischen Bauteil, **dadurch gekennzeichnet, dass** die Realisierung einer Brücke zwischen einem Bereich der Leiterschicht und einem anzusteuernden Kontaktierstreifen (7) die folgenden Schritte umfasst:
- Verlängerung einer Leiterbahn in der Leiterschicht, um ein Leitersegment (1) zu bilden,
- Einschneiden in das Substrat (5), einer wesentlichen rechteckigen Zunge (2, 3), von der eine der Seiten am Substrat (5) verbleibt,
- vorübergehendes Freimachen einer Öffnung durch Druck auf die Zunge (2, 3), wobei sich diese Zunge (2, 3) entlang der am Substrat (5) verbliebenen Seite krümmt,
- Durchquerung dieser Öffnung mit dem Leitersegment (1),
- Umfalten des Segments (1) auf die entgegengesetzte Seite des Substrats (5),
- Wiederverschliessen der Öffnung nach Durchführung des Leitersegments (1) durch Geraderichten der Zunge (2, 3) in ihre anfängliche Lage in der Ebene des Substrats (5),
- Anschluss des Leitersegments (1) an den anzusteuernden Kontaktierstreifen (7).

7. Verfahren nach Anspruch 6, **dadurch gekennzeichnet, dass** der anzusteuernde Kontaktierstreifen auf die Leiterschicht aufgesetzt wird, und dadurch, dass das Leitersegment (1) mit einer zweiten Durchquerung des Substrats vermittels einer zusätzlichen Zunge (2, 3) zu dieser Leiterschicht zurückkehrt, wobei das Leitersegment (1) dann durch die Aktivierung von Kleber, der von der Kleberschicht kommt, am Substrat (5) festgemacht wird.

## Claims

1. Electronic circuit comprising at least one electronic component (6), a substrate (5), constituted by a flexible insulating material, on a first face of this substrate (5) an adhesive layer and a conductive layer including a plurality of tracks (4) are applied, said component (6) including at least two connection areas (7), at least one of these connection areas (7) being electrically linked to the conductive layer by a conductive bridge, **characterized in that** the substrate includes at least one sensibly rectangular strip (2, 3) made by incisions in the substrate (5) on three sides, the last side being attached to said substrate (5), and **in that** the bridge is formed by a conductive segment (1) delimited in the conductive layer only, said segment (1), free from any adhesive substance, traverses the substrate (5) through one of said strip (2, 3) incisions of and links the connection area (7).

2. Electronic circuit according to claim 1, **characterized in that** the substrate (5) includes a second face with a second adhesive layer and a second conductive layer, and **in that** said bridge is formed by a conductive segment (1) delimited in the second conductive layer only, said segment (1), free from any adhesive substance, traverses the substrate (5) by one of said strip (2, 3) incisions and links the connection area (7) and/or the first conductive layer.

3. Electronic circuit according to claims 1 and 2, **characterized in that** a plurality of bridges formed by track segments (1) traverse the substrate (5) through a same incision.

4. Electronic circuit according to the claims 1 to 3, **characterized in that** at least one bridge formed by a track segments (1) traverses the substrate (5) as many times as it is necessary to cross tracks (4) belonging to the conductive layer in order to reach the connection area (7).

5. Chip card or electronic label **characterized in that** it includes an electronic circuit according to the claims 1 to 4.

6. Method for manufacturing an electronic circuit comprising a substrate (5), constituted by a flexible insulating material, at least one adhesive layer and a conductive layer including a plurality of tracks (4) and an electronic component (6),
**characterized in that** the execution of a bridge between a zone of the conductive layer and a target connection area (7), includes the following steps:
- prolonging a track in the conductive layer to constitute a conductive segment (1),
- cutting in the substrate (5) a sensibly rectangular strip (2, 3), one of its sides being attached to the substrate (5).
- temporarily freeing an opening by pressing the strip (2, 3), said strip (2, 3) curving along the side attached to the substrate (5).
- passing the conductive segment (1) through said opening,
- folding the conductive segment (1) against the opposite face of the substrate (5),
- closing the opening after the passage of the conductive segment (1) by straightening the strip (2, 3) towards its initial position at the surface level of the substrate (5).
- connecting the conductive segment (1) to the target connection area (7).

7. Method according to claim 6, **characterized in that** the target connection area is placed on the conductive layer, and **in that** the conductive segment (1) returns to said conductive layer by a second substrate passage by means of a supplementary strip (2, 3), said conductive segment (1) then being fixed to the substrate (5) by activating the glue originating from the adhesive layer.
